# FASCICULE DE BREVET EUROPEEN

(11) **EP 3 136 111 B1**
(45) Date de publication et mention de la délivrance du brevet: **28.11.2018**
(21) Numéro de dépôt: 16186175.2
(22) Date de dépôt: 29.08.2016
(51) Int. Cl.: G01P 3/48, G01P 21/02, B60T 8/171, B60T 8/173

(54) **PROCÉDÉ POUR MESURER LA VITESSE DE ROTATION D'UNE ROUE DE VEHICULE**
VERFAHREN ZUM MESSEN DER DREHGESCHWINDIGKEIT EINES FAHRZEUGRADS
METHOD FOR MEASURING THE ROTATIONAL SPEED OF A VEHICLE WHEEL

(30) Priorité: 31.08.2015 FR 1558072
(43) Date de publication de la demande: 01.03.2017
(73) Titulaire: Safran Landing Systems, 78140 Vélizy-Villacoublay (FR)
(72) Inventeur: ZABULON, Joël, 78140 VELIZY-VILLACOUBLAY (FR); FRANK, David, 78140 VELIZY-VILLACOUBLAY (FR); FALLET, Guillaume, 78140 VELIZY-VILLACOUBLAY (FR)
(74) Mandataire: Lavaud, Thomas

(56) Documents cités:
- DE-A1- 4 440 999
- FR-A1- 2 875 008
- US-A1- 2004 187 581
- US-A1- 2012 024 266
- US-A1- 2012 259 570
- US-B1- 6 445 995

## Description

L'invention concerne la mesure de la vitesse de rotation d'une roue de véhicule.

### ARRIERE PLAN DE L'INVENTION

Les tachymètres généralement utilisés pour mesurer la vitesse de rotation des roues d'aéronefs sont des tachymètres analogiques magnétiques (aussi appelés tachymètres analogiques à technologie inductive).

Un tel tachymètre comporte classiquement une partie tournante solidaire de la roue et équipée d'aimants ou de dentures formées dans un matériau ferromagnétique, et une partie fixe comprenant un capteur magnétique (bobine de fil conducteur, capteur à effet Hall, etc.) délivrant un signal de mesure périodique généré par une variation de champ magnétique résultant de la rotation de la roue.

La fréquence et/ou l'amplitude de ce signal de mesure sont proportionnels à la vitesse de rotation de la roue.

Le signal de mesure est acquis par un module électronique de mesure connecté par un câble au tachymètre.

Lorsque la fréquence du signal de mesure est utilisée pour obtenir la vitesse de rotation de la roue, le module électronique de mesure estime le temps entre deux dépassements d'un seuil de tension (ou de courant) par le signal de mesure, et en déduit la vitesse de rotation de la roue.

Alternativement, le module électronique de mesure utilise un premier seuil de tension sur les valeurs positives du signal de mesure et un deuxième seuil de tension sur les valeurs négatives du signal de mesure (seuillage par hystérésis).

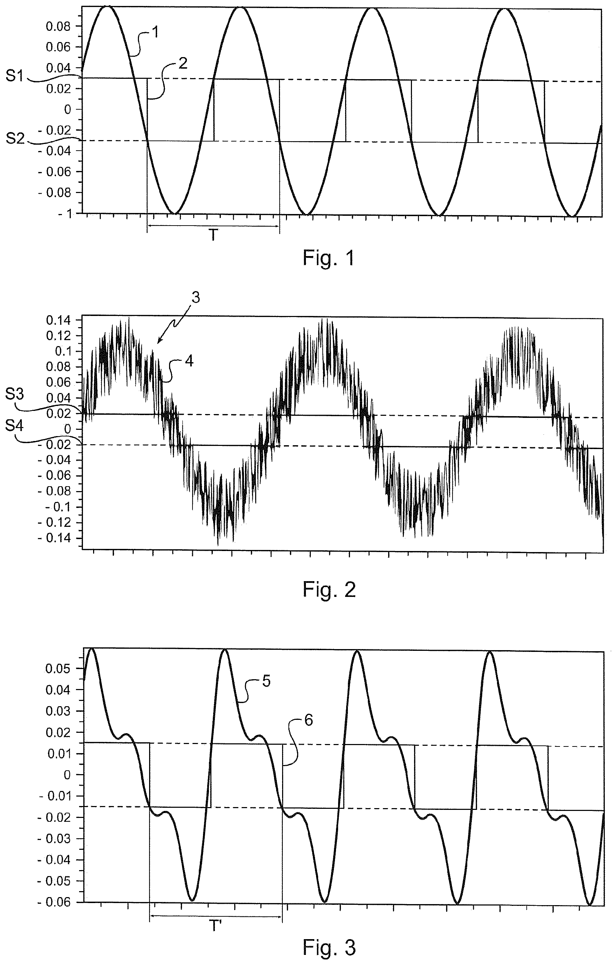

Un tel signal de mesure 1 est représenté sur la figure 1. Le module électronique de mesure génère à partir du signal de mesure 1 et de la comparaison avec un premier seuil de tension S1 et avec un deuxième seuil de tension S2 un signal logique 2. Le signal logique 2 active un « timer » sur l'état montant ou l'état descendant du signal logique 2, ce qui permet d'obtenir une mesure de la période T et donc de la fréquence du signal de mesure 1. On obtient ainsi une mesure de la vitesse de rotation de la roue.

Ce type de mesure présente certains inconvénients. Comme l'amplitude du signal de mesure est moins élevée à faible vitesse de rotation, il existe, pour un seuil de tension donné, une plage de fréquences (et donc de vitesses de rotation) pour lesquelles la mesure de fréquence n'est plus possible. Il semble donc intéressant de réduire ce seuil de tension au maximum. Cependant, la diminution du seuil de tension rend la mesure beaucoup plus sensible aux bruits parasites résultant des diverses perturbations subies par le tachymètre, le module électronique ou le câble : perturbations électriques (bruit des composants), électromagnétiques (moteurs et autres équipements électriques) et mécaniques (répercussion des vibrations et chocs subis par la roue sur la mesure réalisée par le tachymètre).

Ainsi, en utilisant un seuil de 0 volt, tout bruit parasite présent dans le signal de mesure viendra fausser la mesure de la période du signal de mesure.

On observe sur la figure 2 l'impact sur un signal de mesure 3 d'un bruit blanc 4 provoqué par de telles perturbations, le signal de mesure 3 étant comparé avec un premier seuil de tension S3 de 0,02 volts et un deuxième seuil de tension S4 de -0,02 volts. La mesure de la période du signal de mesure 3 est perturbée par la présence du bruit blanc 4 dès lors que l'amplitude du bruit blanc dépasse l'un des premier ou deuxième seuils de tension S3, S4.

Les seuils de tension sont donc particulièrement complexes à définir puisqu'ils conditionnent à la fois les performances de mesure à basse fréquence du tachymètre, mais aussi la robustesse aux bruits de mesure.

Il a été envisagé de filtrer le signal de mesure de manière à réduire les perturbations à haute fréquence se trouvant hors de la bande fréquentielle utile du signal de mesure. Il est cependant impossible de filtrer les bruits à basses fréquences résultant de perturbations d'origine mécanique (par exemple issues de résonances mécaniques à quelques dizaines ou centaines de hertz), car leurs fréquences correspondent à la bande fréquentielle utile du signal de mesure.

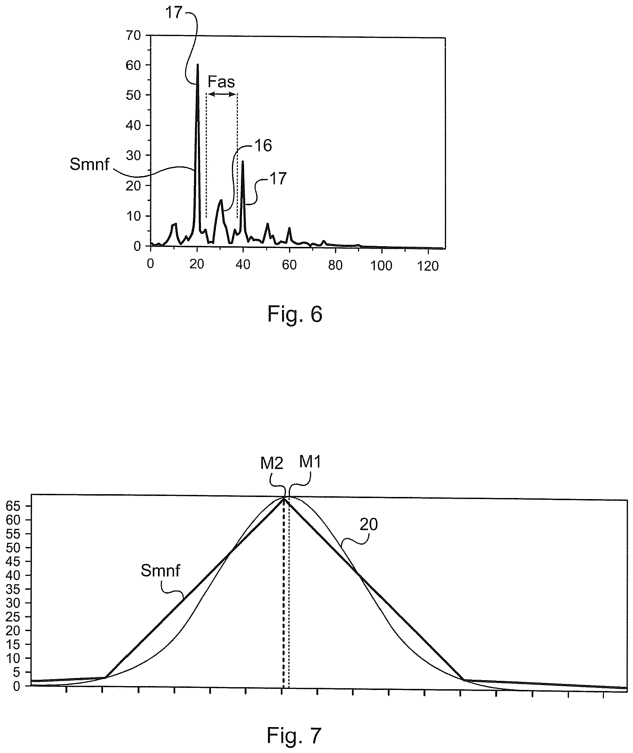

On observe sur la figure 3 un signal de mesure 5 perturbé par une perturbation à basse fréquence. La période T' mesurée du signal logique 6 ne correspond pas à la vitesse de rotation de la roue. Dans cet exemple, la roue tourne à la période 2T', et la présence de perturbations d'origine mécanique génère des raies d'amplitudes supérieures à l'amplitude de la raie utile (dont la fréquence est la fondamentale). On peut observer ce phénomène sur une représentation spectrale du signal en figure 6 où la raie utile 16 présente une amplitude inférieure à celles des raies harmoniques 17 : dans ce cas de figure, la mesure de vitesse est erronée.

FR-A- 2 875 008 divulgue un procédé de détermination d'une vitesse différentielle par analyse fréquentielle des signaux de vitesse. Une transformée de Fourier est calculée pour obtenir un spectre de la vitesse de rotation; la position fréquentielle d'un pic est identifiée dans une fenêtre fréquentielle comprenant une bande correspondant à une harmonique de la fréquence du signal du codeur, qui dépend de la vitesse.

US-A- 2012/024266 concerne un procédé de détermination de la vitesse, par évaluation d'un signal acoustique. Une composante correspondant à la vitesse d'un arbre en rotation est déterminée au moyen d'une évaluation d'une transformée de Fourier. Une recherche de maximum est effectuée dans une fenêtre de fréquences, positionnée en fonction de la vitesse déterminée à un instant précédent. La largueur de la fenêtre peut être adaptée en fonction de l'accélération maximale possible.

### OBJET DE L'INVENTION

L'invention a pour objet d'améliorer la précision et la fiabilité de la mesure de la vitesse de rotation d'une roue d'un véhicule, en particulier lorsque la vitesse de rotation est basse et/ou que l'environnement de la roue est perturbé par des perturbations d'origine électrique, électromagnétique ou mécanique.

### RESUME DE L'INVENTION

En vue de la réalisation de ce but, on propose un procédé pour mesurer la vitesse de rotation d'une roue de véhicule, le procédé comportant les caractéristiques de la revendication 1.

L'utilisation de la transformée de Fourier permet d'étaler dans le domaine spectral le bruit perturbant la mesure, et donc facilite l'identification de la raie utile et la détermination de la vitesse de rotation de la roue, même lorsque la vitesse de rotation de la roue est basse.

D'autres caractéristiques et avantages de l'invention ressortiront à la lecture de la description qui suit d'un mode de réalisation particulier, non limitatif de l'invention.

### BREVE DESCRIPTION DES DESSINS

Il sera fait référence aux dessins annexés parmi lesquels :
- la figure 1 est un graphique sur lequel est représenté un signal de mesure non bruité produit par un tachymètre magnétique destiné à mesurer une vitesse de rotation d'une roue de véhicule selon une méthode de l'art antérieur ;
- la figure 2 est une figure analogue à la figure 1, sur laquelle le signal de mesure est perturbé par un bruit blanc ;
- la figure 3 est une figure analogue à la figure 1, sur laquelle le signal de mesure est perturbé par une perturbation basse fréquence ;
- la figure 4 est un schéma d'un module électronique de mesure utilisé pour mettre en oeuvre le procédé de l'invention ;
- la figure 5 représente un signal de mesure numérique fréquentiel obtenu par le procédé de l'invention et perturbé par un bruit blanc ;
- la figure 6 représente un signal de mesure numérique fréquentiel résultant, lors de la mise en oeuvre du procédé de l'invention, du calcul de la transformée de Fourier d'un signal de mesure analogique perturbé par un bruit d'origine mécanique ;
- la figure 7 représente une interpolation par une courbe gaussienne d'un signal de mesure numérique fréquentiel obtenu par le procédé de l'invention.

### DESCRIPTION DETAILLEE DE L'INVENTION

Le procédé de l'invention est ici mis en oeuvre pour mesurer la vitesse de rotation d'une roue d'un aéronef.

La roue de l'aéronef est équipée d'un tachymètre magnétique qui est connecté, via un câble cheminant le long d'un atterrisseur portant la roue, à un module électronique de mesure intégré dans un calculateur déporté situé dans une soute de l'aéronef. Le procédé de l'invention est ici mis en oeuvre par le module électronique de mesure.

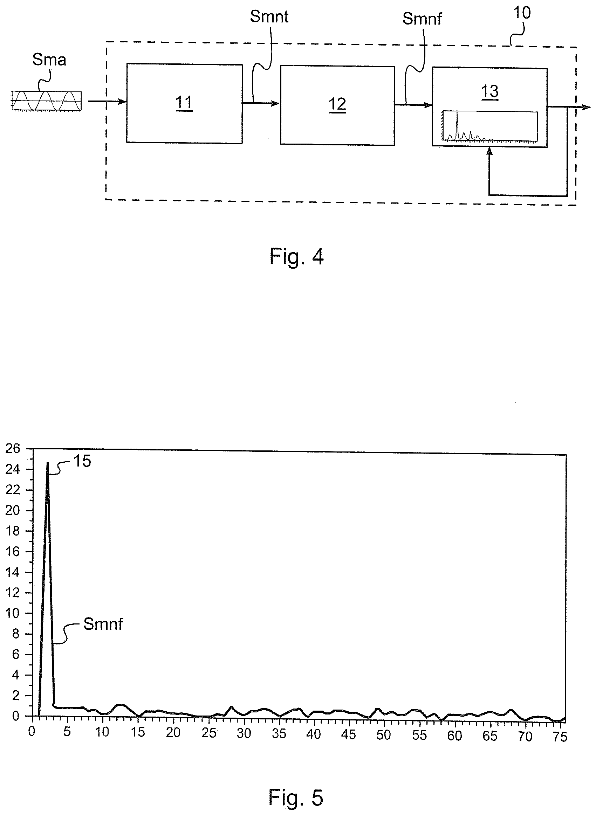

En référence à la figure 4, le module électronique de mesure 10 comporte un convertisseur analogique-numérique 11, un module de calcul 12 et un module d'analyse fréquentielle 13.

Le tachymètre génère, lorsque la roue tourne, un signal de mesure analogique Sma. Le signal de mesure analogique Sma contient un signal utile dont la fréquence est représentative de la vitesse de rotation de la roue, et un bruit indésirable résultant des perturbations d'origine électrique, électromagnétique ou mécanique auxquelles sont soumis le tachymètre, le câble et le module électronique de mesure 10 intégré dans le calculateur déporté. La fréquence du signal utile est ici proportionnelle à la vitesse de rotation de la roue.

Le signal de mesure analogique Sma est acquis en temps réel par le module électronique de mesure 10 et transmis au convertisseur analogique-numérique 11. Le convertisseur analogique-numérique 11 convertit en temps réel le signal de mesure analogique Sma (il s'agit en l'occurrence d'une tension de mesure) en un signal de mesure numérique temporel Smnt. Le convertisseur analogique-numérique 11 utilisé est ici un convertisseur 12 bits. Avec un tel convertisseur analogique-numérique, on peut convertir en un signal numérique un signal de mesure analogique dont l'amplitude varie entre 5 volts crête/crête et 2,5 millivolts crête/crête, ce qui permet de traiter des signaux de mesure analogique de très faible amplitude et donc de mesurer des vitesses de rotation de la roue de l'aéronef nettement inférieures aux vitesses minimales des tachymètres classiques.

Le signal de mesure numérique temporel Smnt est ensuite transmis au module de calcul 12 qui comprend un composant de traitement (par exemple de type microcontrôleur classique ou DSP). Le signal de mesure numérique temporel Smnt est multiplié par une fenêtre d'observation qui permet notamment de définir une durée du signal de mesure numérique temporel Smnt analysé. La fenêtre d'observation est typiquement une fenêtre de Hamming, de Blackman, etc.

Le module de calcul 12 calcule la transformée de Fourier du signal de mesure numérique temporel Smnt sur la fenêtre d'observation. Le module de calcul 12 produit un signal de mesure numérique fréquentiel Smnf qui constitue une représentation instantanée du spectre du signal de mesure numérique temporel Smnt sur la durée du signal de mesure numérique temporel Smnt analysé.

Le module d'analyse fréquentielle 13 réalise une analyse fréquentielle sur le signal de mesure numérique fréquentiel Smnf de manière à identifier une raie utile et à déterminer la fréquence de la raie utile pour obtenir la fréquence du signal utile représentative de la vitesse de rotation de la roue.

La détermination de la fréquence de la raie utile et donc l'analyse fréquentielle, sont particulièrement simples lorsque le bruit indésirable est un bruit blanc large bande. En effet, dans ce cas, la transformée de Fourier appliquée au signal de mesure numérique temporelle Smnt améliore de manière très nette le rapport signal sur bruit dans le domaine fréquentiel en étalant le bruit blanc dans la totalité de la bande passante.

Ainsi, en référence à la figure 5, on détermine aisément grâce à une recherche de maximum dans l'ensemble du domaine fréquentiel la raie utile 15 du signal de mesure numérique fréquentiel Smnf qui correspond au signal de mesure 3 de la figure 2.

On note cependant que l'analyse fréquentielle est plus complexe dans un certain nombre de situations. Ainsi, en présence de bruits résultant de perturbations d'origine mécanique, les déformations du signal de mesure analogique Sma se traduisent dans le domaine fréquentiel par l'apparition de raies harmoniques d'amplitude importante. On voit sur la figure 6 que la raie utile 16 présente une amplitude inférieure aux raies harmoniques 17 lorsque l'environnement de la roue de l'aéronef subit des perturbations d'origine mécanique. La recherche de maximum sur l'ensemble du domaine fréquentiel ne permet pas de déterminer la raie utile 16.

Pour pallier à ce problème, on met en oeuvre un filtrage adaptatif qui consiste, dans le domaine fréquentiel, à adapter la position d'une fenêtre d'analyse spectrale Fas dans laquelle est supposée se trouver la raie utile 16 et dans laquelle l'amplitude de la raie utile 16 correspond au maximum du signal de mesure numérique fréquentiel Smnf.

On détermine ainsi grâce à une recherche de maximum dans la fenêtre d'analyse spectrale Fas la fréquence de la raie utile 16 pour obtenir la fréquence du signal utile représentative de la vitesse de rotation de la roue.

L'adaptation de la position de la fenêtre d'analyse spectrale Fas est réalisée en fonction d'une prédiction de la fréquence de la raie utile 16. A chaque instant d'acquisition t d'une mesure de vitesse, la prédiction de la fréquence de la raie utile 16 est réalisée en fonction de la fréquence de la raie utile 16 déterminée à l'instant précédent d'acquisition t-1. On centre ainsi la fenêtre d'analyse spectrale Fas sur la fréquence prédite de la raie utile 16, et on recherche la fréquence effective de la raie utile sur la fenêtre d'analyse spectrale Fas par une recherche de maximum.

L'initialisation de la position de la fenêtre d'analyse spectrale Fas dépend des conditions dans lesquelles se trouve l'aéronef préalablement à la mise en oeuvre du procédé de l'invention, c'est-à-dire préalablement au moment où l'on commence à acquérir des mesures de vitesse de rotation de la roue pour les exploiter.

Lorsque l'aéronef est à l'arrêt au moment où le procédé de l'invention est mis en oeuvre, la position de la fenêtre d'analyse spectrale Fas est initialisée de manière à ce que la fenêtre d'analyse spectrale Fas soit centrée sur une fréquence d'initialisation nulle.

Lorsque l'aéronef est sur le point d'atterrir et que la vitesse de rotation mesurée de la roue est sur le point de passer d'une valeur nulle à une valeur très importante, la position de la fenêtre d'analyse spectrale Fas est initialisée de manière à ce que la fenêtre d'analyse spectrale Fas soit centrée sur une fréquence d'initialisation correspondant à cette valeur importante de vitesse. La fréquence d'initialisation est obtenue grâce à des mesures de vitesse de l'aéronef fournies par d'autres capteurs de l'aéronef (par exemple la centrale inertielle), ou bien à partir de données de navigation ou de calculs effectués par un calculateur de freinage de l'aéronef.

De même, lorsque l'environnement de la roue et/ou du câble et/ou du module électronique de mesure 10 sont particulièrement perturbés et que le signal de mesure numérique fréquentiel Smnf est très bruité, la fréquence d'initialisation est obtenue grâce à des mesures de vitesse de l'aéronef fournies par d'autres capteurs de l'aéronef (par exemple la centrale inertielle), ou bien à partir de données de navigation ou de calculs effectués par un calculateur de freinage de l'aéronef.

Ainsi, dans la situation illustrée sur la figure 6, une fréquence d'initialisation précise à +/-4 tours par minute associée à une fenêtre de 10 tours par minute de largeur permet d'éliminer les harmoniques 17 à gauche et à droite de la raie utile 16 et d'initialiser efficacement la prédiction.

La largeur de la fenêtre d'analyse spectrale Fas est quant à elle adaptée en fonction du niveau des perturbations présentes dans le signal de mesure numérique fréquentiel Smnf. En particulier, si les perturbations d'origine mécanique sont faibles, l'amplitude des raies correspondantes est très faible par rapport à l'amplitude de la raie utile 16, et le problème décrit plus tôt et apparent sur la figure 6 n'existe plus. Il est donc possible d'augmenter la largeur de la fenêtre d'analyse spectrale Fas, voire même de rechercher la raie utile 16 par une recherche de maximum sur l'ensemble du spectre.

Avantageusement, on réalise une interpolation du signal de mesure numérique fréquentiel Smnf préalablement à l'analyse fréquentielle dudit signal de mesure numérique fréquentiel Smnf. L'interpolation permet de réduire les discontinuités du signal de mesure fréquentiel numérique Smnf résultant de la quantification des informations liée à la transformation de Fourier qui produit un certain nombre d'échantillons équi-répartis dans le domaine fréquentiel. On situe ainsi plus précisément le maximum du signal de mesure numérique fréquentiel Smnf et on améliore la recherche de la raie utile 16.

On voit sur la figure 7 que la position du maximum M1 obtenue sur une courbe d'interpolation gaussienne 20 est légèrement différente de la position du maximum M2 recherché sur le signal de mesure numérique fréquentiel Smnf purement échantillonné. L'interpolation n'est pas nécessairement une interpolation par une courbe gaussienne et peut être une interpolation par une courbe simple, parabolique, etc.

Avantageusement, le module d'analyse fréquentielle 13 produit un indicateur de qualité du signal de mesure numérique fréquentiel Smnf. L'indicateur de qualité est ici produit à partir du nombre de raies indésirables (correspondant à du bruit résultant de perturbations, à des harmoniques, etc.) détectées au cours de l'analyse fréquentiel.

Si aucune raie indésirable n'est détectée, il est certain que la raie utile déterminée correspond bien à la fréquence du signal utile et donc à la vitesse de rotation de la roue. L'indicateur de qualité est donc excellent et la qualité et l'intégrité de la mesure peuvent être garanties.

Au contraire, si de nombreuses raies indésirables sont détectées, il peut être nécessaire de croiser la mesure de la vitesse de rotation de la roue avec celles d'autres roues ou avec des données fournies par d'autres capteurs de l'aéronef. Si la mesure est confirmée, le module d'analyse fréquentielle affecte à la mesure un bon indicateur de qualité. Si les capteurs fournissent une mesure différente, le module d'analyse fréquentielle affecte à la mesure un mauvais indicateur de qualité.

L'indicateur de qualité est ici destiné notamment à être utilisé pour d'autres opérations de filtrage des mesures, cette fois dans le domaine temporel.

Avantageusement, un algorithme de surveillance utilise l'évolution du facteur de qualité pour établir un diagnostic sur l'évolution de l'usure du tachymètre, du câble, et de la dégradation du fonctionnement du module de mesure électronique 10. L'algorithme de surveillance diagnostique ainsi un tachymètre et/ou un câble et/ou un module électronique de mesure 10 défaillants lorsque le facteur de qualité se dégrade au-delà d'un certain seuil de qualité. L'algorithme de surveillance peut aussi anticiper la défaillance du tachymètre et/ou du câble et/ou du module électronique de mesure 10 grâce à l'évolution du facteur de qualité et donc informer le pilote de l'aéronef, ou bien des opérateurs de maintenance, des opérations à réaliser avant que le système formé par le tachymètre, le câble et le module de mesure électronique devienne non-opérationnel.

L'invention n'est pas limitée au mode de réalisation particulier qui vient d'être décrit, mais, bien au contraire, couvre toute variante entrant dans le cadre de l'invention tel que défini par les revendications.

Bien que l'on ait mis en oeuvre le procédé de l'invention pour mesurer la vitesse de rotation d'une roue d'aéronef, celui-ci peut parfaitement être utilisé pour mesurer la vitesse de rotation d'une roue d'un véhicule différent (automobile, etc.).

## Revendications

1. Procédé pour mesurer la vitesse de rotation d'une roue de véhicule comportant les étapes de :
- acquérir un signal de mesure analogique (Sma) généré par un tachymètre magnétique et contenant un signal utile dont la fréquence est représentative de la vitesse de rotation de la roue ;
- numériser en temps réel le signal de mesure analogique (Sma) pour obtenir un signal de mesure numérique temporel (Smnt) ;
- calculer une transformée de Fourier du signal de mesure numérique temporel (Smnt) sur une fenêtre d'observation pour obtenir un signal de mesure numérique fréquentiel (Smnf) ;
- réaliser une analyse fréquentielle du signal de mesure numérique fréquentiel de manière à identifier par une recherche de maximum une raie utile (15 ; 16) et à déterminer la fréquence de la raie utile pour obtenir la fréquence du signal utile et donc la vitesse de rotation de la roue,
l'analyse fréquentielle comportant la mise en oeuvre d'un filtrage adaptatif, le filtrage adaptatif consistant à adapter la position d'une fenêtre d'analyse spectrale (Fas) dans laquelle est supposée se trouver la raie utile (15 ; 16) en fonction d'une prédiction de la fréquence de la raie utile (15 ; 16), la largeur de la fenêtre d'analyse spectrale (Fas) étant adaptée en fonction du niveau des perturbations présentes dans le signal de mesure numérique fréquentiel (Smnf).

2. Procédé selon la revendication 1, dans lequel la prédiction de la fréquence de la raie utile à un certain instant dépend de la fréquence de la raie utile déterminée à un instant précédent.

3. Procédé selon la revendication 2, dans lequel la prédiction de la fréquence de la raie utile est initialisée avec une fréquence d'initialisation nulle lorsque le véhicule est à l'arrêt avant que le procédé ne soit mis en oeuvre.

4. Procédé selon la revendication 2, dans lequel la prédiction de la fréquence de la raie utile est initialisée avec une fréquence d'initialisation fournie par un autre capteur du véhicule lorsque le véhicule n'est pas à l'arrêt avant que le procédé ne soit mis en oeuvre.

5. Procédé selon l'une des revendications précédentes, dans lequel une interpolation de type parabolique, gaussienne ou simple est réalisée sur le signal de mesure numérique fréquentiel (Smnf).

6. Procédé selon l'une des revendications précédentes, dans lequel un indicateur de qualité de la mesure de la vitesse de rotation de la roue est calculé en fonction de caractéristiques de qualité du signal de mesure numérique fréquentiel.

7. Procédé selon la revendication 6, dans lequel l'indicateur de qualité est fonction du nombre de raies (17) présentes dans le signal de mesure numérique fréquentiel (Smnf).

8. Procédé selon la revendication 6, dans lequel le calcul de l'indicateur de qualité intègre des résultats de mesure fournis par un autre capteur du véhicule.

9. Procédé selon la revendication 6, dans lequel l'indicateur de qualité est utilisé pour fournir un diagnostic de l'état du tachymètre magnétique et/ou d'un autre équipement utilisé pour acquérir le signal de mesure analogique (Sma).

## Patentansprüche

1. Verfahren zum Messen der Rotationsgeschwindigkeit eines Fahrzeugrades, umfassend die Schritte:
- Erfassen eines analogen Messsignals (Sma), das von einem magnetischen Tachometer erzeugt wird und ein Nutzsignal enthält, dessen Frequenz repräsentativ für die Rotationsgeschwindigkeit des Rades ist;
- Digitalisieren in Echtzeit des analogen Messsignals (Sma), um ein zeitabhängiges digitales Messsignal (Smnt) zu erhalten;
- Berechnen einer Fourier-Transformierten des zeitabhängigen digitalen Messsignals (Smnt) in einem Beobachtungsfenster, um ein frequenzabhängiges digitales Messsignal (Smnf) zu erhalten;
- Durchführen einer Frequenzanalyse des frequenzabhängigen digitalen Messsignals, um durch eine Suche nach Maximalwerten eine Nutzlinie (15; 16) zu identifizieren und die Frequenz der Nutzlinie zu bestimmen, um die Frequenz des Nutzsignals und demzufolge die Rotationsgeschwindigkeit des Rades zu erhalten,
wobei die Frequenzanalyse das Durchführen einer adaptiven Filterung umfasst, wobei die adaptive Filterung darin besteht, die Position eines Spektralanalysefensters (Fas), in dem sich die Nutzlinie (15; 16) befinden soll, in Abhängigkeit einer Vorhersage der Frequenz der Nutzlinie (15;16) anzupassen, wobei die Breite des Spektralanalysefensters (Fas) in Abhängigkeit der Höhe der Störungen angepasst wird, die in dem frequenzabhängigen digitalen Messsignal (Smnf) vorhanden sind.

2. Verfahren nach Anspruch 1, bei dem die Vorhersage der Frequenz der Nutzlinie zu einem bestimmten Zeitpunkt von der Frequenz der Nutzlinie abhängt, die zu einem vorhergehenden Zeitpunkt bestimmt wurde.

3. Verfahren nach Anspruch 2, bei dem die Vorhersage der Frequenz der Nutzlinie mit einer Initialisierungsfrequenz von Null initialisiert wird, wenn das Fahrzeug steht, ehe das Verfahren durchgeführt wird.

4. Verfahren nach Anspruch 2, bei dem die Vorhersage der Frequenz der Nutzlinie mit einer Initialisierungsfrequenz initialisiert wird, die von einem anderen Sensor des Fahrzeugs geliefert wird, wenn das Fahrzeug nicht steht, ehe das Verfahren durchgeführt wird.

5. Verfahren nach einem der vorhergehenden Ansprüche, bei dem an dem frequenzabhängigen digitalen Messsignal (Smnf) eine Interpolation der Art Parabolinterpolation, Gaußsche-Interpolation oder einfache Interpolation durchgeführt wird.

6. Verfahren nach einem der vorhergehenden Ansprüche, bei dem eine Qualitätsanzeige zum Anzeigen der Qualität der Messung der Rotationsgeschwindigkeit des Rades in Abhängigkeit von Qualitätsmerkmalen des frequenzabhängigen digitalen Messsignals berechnet wird.

7. Verfahren nach Anspruch 6, bei dem die Qualitätsanzeige von der Anzahl der Linien (17) abhängt, die in dem frequenzabhängigen digitalen Messsignal (Smnf) vorhanden sind.

8. Verfahren nach Anspruch 6, bei dem die Berechnung der Qualitätsanzeige Messergebnisse integriert, die von einem anderen Sensor des Fahrzeugs geliefert werden.

9. Verfahren nach Anspruch 6, bei dem die Qualitätsanzeige verwendet wird, um eine Diagnose des Zustandes des magnetischen Tachometers und/oder eines anderen Geräts zu liefern, das verwendet wird, um das analoge Messsignal (Sma) zu erfassen.

## Claims

1. Method of measuring the speed of rotation of a vehicle wheel, comprising the steps of:
- acquiring an analogue measuring signal (Sma) which is generated by a magnetic tachometer and which contains a useful signal whose frequency is representative of the speed of rotation of the wheel;
- digitising the analogue measuring signal (Sma) in real time to obtain a digital time-domain measuring signal (Smnt);
- calculating a Fourier transform of the digital time-domain measuring signal (Smnt) over a window of observation to obtain a digital frequency-domain measuring signal (Smnf);
- performing a frequency analyis of the digital frequency-domain measuring signal in such a way as to identify, by a search for a maximum, a useful spectral line (15; 16) and to determine the frequency of the useful spectral line in order to obtain the frequency of the useful signal and hence the speed of rotation of the wheel,
the frequency analysis comprising the use of adaptive filtering, the adaptive filtering comprising adapting, as a function of a prediction of the frequency of the useful spectral line (15; 16), the position of a spectrum analysis window (Fas) in which the useful spectral line (15; 16) is assumed to be situated, the width of the spectrum analysis window (Fas) being adapted as a function of the level of the disruptions present in the digital frequency-domain measuring signal (Smnf).

2. Method according to claim 1, wherein the prediction of the frequency of the useful spectral line at a given moment depends on the frequency of the useful spectral line as determined at a previous moment.

3. Method according to claim 2, wherein the prediction of the frequency of the useful spectral line is initialised with an initialising frequency of zero when the vehicle is stationary before the method is carried out.

4. Method according to claim 2, wherein the prediction of the frequency of the useful spectral line is initialised with an initialising frequency supplied by another sensor belonging to the vehicle when the vehicle is not stationary before the method is carried out.

5. Method according to one of the preceding claims, wherein an interpolation of the parabolic, gaussian or simple type is performed on the digital frequency-domain measuring signal (Smnf).

6. Method according to one of the preceding claims, wherein an indicator of the quality of the measurement of the speed of rotation of the wheel is calculated as a function of quality characteristics of the digital frequency-domain measuring signal.

7. Method according to claim 6, wherein the quality indicator is a function of the number of spectral lines (17) present in the digital frequency-domain measuring signal (Smnf).

8. Method according to claim 6, wherein the calculation of the quality indicator incorporates measured results provided by another sensor belonging to the vehicle.

9. Method according to claim 6, wherein the quality indicator is used to provide a diagnosis of the state of the magnetic tachometer and/or of another piece of equipment used to acquire the analogue measuring signal (Sma).
